(19)

**Europäisches Patentamt**
**European Patent Office**
**Office européen des brevets**

(11) **EP 3 534 423 A1**

(12) **EUROPEAN PATENT APPLICATION**

(43) Date of publication:
04.09.2019 Bulletin 2019/36

(51) Int Cl.:
*H01L 51/42* (2006.01)　　*C09K 11/00* (2006.01)
*C08K 3/16* (2006.01)　　*C08K 5/17* (2006.01)

(21) Application number: 18159370.8

(22) Date of filing: 01.03.2018

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **SABIC Global Technologies B.V.
4612 PX Bergen op Zoom (NL)**

(72) Inventors:
• **SANG HOON, Kim**
  **Seoul (KR)**
• **HYUN, Soonyoung**
  **Gyeonnggi-do (KR)**

(74) Representative: **Elzaburu S.L.P.
Miguel Angel 21, 2nd floor
28010 Madrid (ES)**

(54) **PEROVSKITE QUANTUM DOT LAYER**

(57) A film for light emitting devices is disclosed. The film may comprise a polymer layer. The film may comprise a plurality of first quantum dots disposed in the polymer layer and that emit light in a first wavelength range upon excitation. The plurality of first quantum dots may comprise a first zero dimensional perovskite material. The first zero dimension perovskite material may have an emission property based on a quantum confinement state. The film may comprise a plurality of second quantum dots disposed in the polymer layer and that emit light in a second wavelength range upon excitation. The plurality of second quantum dots may comprise a second zero dimensional perovskite material.

EP 3 534 423 A1

**Description**

<u>Technical Field</u>

The disclosure generally relates to a quantum dot film, and more particularly to methods and structures utilizing a quantum dot film.

<u>Background</u>

Quantum dots (QDs) represent an area of expanding technological interest as a promising class of emissive materials. QDs provide size-tunable electronic, optical and chemical properties. QDs may display comparatively strong emission in the visible region of the electromagnetic spectrum while the wavelength of light absorbed and emitted by the QD is a function of the size of the QD. Conventional quantum dot films (QD films) are composed of a quantum dot layer and two barrier films in order to protect the quantum dots material. Conventional quantum dots are easily damaged by oxygen and moisture if exposed to them. Therefore barrier films are typically used to protect QDs from moisture. However the addition of barrier films increases QD film price as well as the film thickness. These conventional QD films are difficult to implement into mobile devices where the requirements in thickness may be below 100um. Using barrier film makes optical light path longer than barrier free concept QD film, resulting in optical loss such as QY, luminance, and transmittance as well. For instance, optical transparency of barrier film may be less than 93% in the wavelength range of between 430 and 650nm.

Various teachings are known in the art that relate to quantum dot films, polymers, or other features related to the disclosure. For example, EP1144075B1 discloses a porous polymeric sheet having an electrostatic charge and comprising a zero-three composite of a polymeric matrix and a ferroelectric material dispersed therein.

US7741396B2 discloses a composition comprising a polymeric material and perovskites, the dielectric constant of a composition is tunable and the composition has a dielectric constant of about 2 to about 100.

US6162535A discloses a fiber which includes a thermoplastic polymer and particles of a ferroelectric material dispersed therein.

US20090045544A1 discloses a method for manufacturing an ultra-thin polymeric film is disclosed including the steps of melt blending of a polymeric composition or a nanocomposite composition in an extruder and conveying the molten composition through a flat die with a small die lip gap, and using a melt pump to provide a constant, non-pulsating flow of the melted composition through the die.

These teachings in the art have shortcomings in function, cost, and/or other aspects. For example, certain optical constructions or devices making use of quantum dots may be hindered and result in reduced conversion efficiency and color gamut. Thus, there is a need for improved quantum dot films.

<u>Summary</u>

A film for light emitting devices is disclosed. In an aspect, the film may comprise a polymer layer. The film may comprise a plurality of first quantum dots disposed in the polymer layer and that emit light in a first wavelength range upon excitation. The plurality of first quantum dots may comprise a first zero dimensional perovskite material. The first zero dimension perovskite material may have an emission property based on a quantum confinement state. The film may comprise a plurality of second quantum dots disposed in the polymer layer and that emit light in a second wavelength range upon excitation. The plurality of second quantum dots may comprise a second zero dimensional perovskite material.

In another aspect, a multi-layer film may comprise a first layer comprising a plurality of first quantum dots disposed in a first polymer and that emit light in a first wavelength range upon excitation. The plurality of first quantum dots may comprise a first zero dimensional perovskite material. The first zero dimension perovskite material may have an emission property based on a quantum confinement state. The multi-layer film may comprise a second layer comprising a plurality of second quantum dots disposed in a second polymer and that emit light in a second wavelength range upon excitation. The plurality of second quantum dots may comprise a second zero dimensional perovskite material.

In yet another aspect, a method may comprise forming a plurality of first quantum dots that emit light in a first wavelength range upon excitation. The plurality of first quantum dots may comprise a first zero dimensional perovskite material. The first zero dimension perovskite material may have an emission property based on a quantum confinement state. The method may comprise forming a plurality of second quantum dots that emit light in a second wavelength range upon excitation. The plurality of second quantum dots may comprise a second zero dimensional perovskite material. The method may comprise forming a combination of the plurality of first quantum dots, the plurality of second quantum dots, and at least one polymer. The method may comprise forming the combination into a structure.

Brief Description of the Drawings

The above-mentioned and other features and advantages of this disclosure, and the manner of attaining them, will become apparent and be better understood by reference to the following description of one aspect of the disclosure in conjunction with the accompanying drawings, wherein:

FIG. 1A is a diagram illustrating an example single layer quantum dot film.
FIG. 1B is a diagram illustrating an example single layer quantum dot film with texturing.
FIG. 2A is a diagram illustrating an example double layer quantum dot film.
FIG. 2B is a diagram illustrating an example multi-layer quantum dot film.
FIG. 3A is a diagram illustrating another example multi-layer quantum dot film.
FIG. 3B is a diagram illustrating an example a multi-layer quantum dot film with texturing.
FIG. 4A is a diagram illustrating another example multi-layer quantum dot film.
FIG. 4B is a diagram illustrating another example multi-layer quantum dot film with texturing.
FIG. 4C is a diagram illustrating yet another example multi-layer quantum dot film.
FIG. 4D is a diagram illustrating yet another example multi-layer quantum dot film with texturing.
FIG. 5A is a diagram illustrating an example backlight structure.
FIG. 5B is a diagram illustrating an example optical device.
FIG. 6 is a diagram illustrating an example method of forming a structure in according with the present disclosure.

Detailed Description

The present disclosure relates to zero dimensional perovskite material disposed in a film, such as a quantum dot (QD) film. Perovskite with zero dimensional structure has a much greater stability and reliability under atmosphere condition as compared to conventional quantum dot or normal perovskite materials. In order to increase QY performance and luminance, the present approaches comprise a structure (e.g., co-extrusion structure) comprising a zero dimensional perovskite material. Co-extrusion or multi-layer extrusion may be used to form a film with one or more layers of zero-dimensional perovskite material. Through this approach, the FRET phenomenon may be avoided, which is non-radiative energy transfer from a fluorescent donor to a lower energy acceptor via long-range dipole-dipole interactions. This process occurs if two particles are close to each other, such as less than 20 nm apart.

Incumbent material such as CdS, CdTe, ZnS, and other perovskite materials are very unstable and weak to moisture and gases. To enhance the stability of these QD materials, encapsulation technology is typically introduced. However, defects might be generated during encapsulation process and optical performance might become deteriorate due to the additional encapsulation layer. The present methods, devices, and films use highly stable perovskite material for the application of QD film. This perovskite material can be adjustable in size (e.g., even micron size may be used to secure stability and reliability of zero dimensional perovskite). The use of zero dimensional perovskite materials allows for the removal of barrier film for QD film and the solution process of QD material. Mixing with plastic pellet and zero dimensional perovskite may be sufficient before extrusion process.

Perovskite material may be composed of $ABX_3$ structure. A stands for organic or inorganic monovalent cation (e.g., $CH_3NH_3$ or $Cs^+$), B stands for bivalent cation (e.g., $Pb^{2+}$, $Sn^{2+}$ or $Bi^{2+}$) and X means halogen anion (e.g., $Cl^-$, $Br^-$ or $I^-$). General formula of perovskite can also be expressed as $A_nBX_{n+2}$. When n= 1, this structure shows three dimensional (3D) perovskite (e.g., crystal structure is based on the corner-shared $PbBr_6^{4-}$ octahedra). This structure is called conventional bulk perovskites, which are not optically emissive due to the shared octahedra of the crystal structure that prevent quantum confinement of the charge carriers. As a result, low exciton binding energies (~15-50 meV) occur, which relates to non-emissive properties. When n =2 ~ 4, the structure are so called as low dimensional perovskite. When n=2, the structure is called two dimensional perovskite (e.g., octahedra form planes). When n=3, the structure is called one dimensional perovskite (e.g., octahedra form chains). When n=4, the structure is called zero dimensional perovskite (e.g., octahedra form isolated dots).

To achieve quantum confinement and ensure high PLQY, two approaches are disclosed. One approach contemplated by the present disclosure is to make physical change in size and thickness. Perovskite can show quantum dot effect when its size is reduced to nanoscale. However, PLQY of quantum dots may decrease when the quantum dots go into aggregation. In case of making perovskite thin film, abundance of grain boundaries can give detrimental effect to the material's stability. Another approach contemplated by the present disclosure is to use structure dimensionality change.

Among them, zero dimensional perovskite has a greater ability in enhancing PLQY due to the increase in the exciton binding energy. In an example zero dimensional perovskite, $Cs^+$ ions can minimize the electronic overlap between adjacent octahedra, resulting in localized states that are confined to the individual octahedral.

In conventional quantum dot films, a quantum dot layer is disposed between a first barrier film and a second barrier film in order to protect the quantum dot from degradation factors such as oxygen and moisture. Suitable barrier films include substrate (e.g. PET), oxides (e.g., silicon oxides, metal oxides, metal nitrides, metal carbides, metal oxynitrides), and/or the like. The barrier layers are typically formed using techniques employed in the film metallizing art such as sputtering, evaporation, chemical vapor deposition, plasma deposition, atomic layer deposition, plating and the like. The second barrier film is preferably laminated on the quantum dot layer and the thickness of each barrier layer is sufficiently thick to eliminate wrinkling in roll-to-roll or laminate manufacturing processes. Therefore, removing the use of barrier film in a zero dimensional perovskite film is more cost competitive and results in a thinner film. Removing the use of barrier films can provide customers with greater design freedom. In mobile and portable and large size display and wearable application, the use of the present disclosure to eliminate the need for barrier films will be very useful.

In present disclosure, stable zero dimensional perovskite embedded film are disclosed. The zero dimensional perovskite embedded film may be formed by extruding. Extruding may be used instead of solvent casting and polymerization, such as thermal or UV curing with barrier films to protect the quantum dot layer from oxygen and moisture. In order to increase optical properties of the film, the perovskite film may comprise optical features, such as diffuser, MLA, Prism function, or a combination thereof. Conventional QD film has many seam lines between the each functional layer such as bottom barrier-QD and later-top barrier. The use of conventional barriers may comprise many functional layers, such as a diffuser layer, a PET substrate, an inorganic barrier layer, an adhesive layer for good adhesion property, and/or other layers between barrier layer and QD layer. These many layers can induce a lot of optical loss in each layer because of different refractive index of each layer. In order to mitigate the optical properties, the present films may comprise homogeneous material film without seam lines between each layer. Perovskite film may provide more stable color conversion than conventional QD film because of barrier-free solution. Incumbent QD film requires scattering beads such as $TiO_2$, $SiO_2$, $Al_2O_3$, while zero dimensional perovskite embedded film as disclosed herein does not require scattering materials (e.g., because zero dimensional perovskite itself may have a micron size so that scattering occurs naturally).

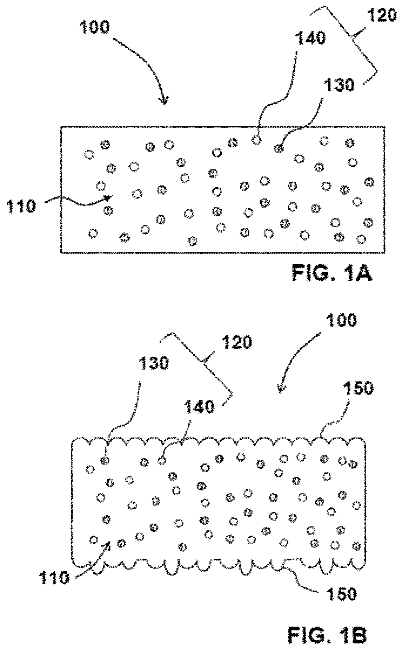

With reference to FIG. 1A, aspects of the disclosure relate to a film 100. The film 100 may comprise a quantum dot film. The film 100 may comprise a zero dimensional perovskite film. The film 100 may comprise at least one polymer layer 110. The at least one polymer layer 110 may comprise a polymer layer, such as an extruded polymer layer. A plurality of quantum dots 120 may be disposed in the at least one polymer layer 110.

The plurality of quantum dots 120 may comprise a plurality of first quantum dots 130 (e.g., disposed in the at least one polymer layer). The plurality of first quantum dots 130 may emit light in a first wavelength range upon excitation. The plurality of quantum dots 120 may comprise a plurality of second quantum dots 140 (e.g., disposed in the at least one polymer layer). The plurality of second quantum dots 140 may emit light in a second wavelength range upon excitation.

The plurality of first quantum dots 130 may comprise a first zero dimensional perovskite material. The first zero dimension perovskite material may have an emission property based on a quantum confinement state. Electrical overlap between adjacent octahedra of first zero dimensional perovskite material may be minimized in the quantum confinement state. The quantum confinement state may confine a charge carrier to a molecule of the first zero dimensional perovskite material.

The electrical overlap between adjacent octahedra may be minimized in comparison to a conventional perovskite material. For example, the first zero dimensional perovskite material may comprise an octahedra structure having localized electron states isolated from other octahedra structures of the first zero dimensional perovskite material. The conventional perovskite material may comprise octahedra forming one or more of one-dimensional chains, two-dimensional planes, or three-dimensional structures. The conventional perovskite material may be defined by $A_nBX_{n+2}$, where A comprises a monovalent cation, B comprises a bivalent cation, X comprises a halogen anion, and n is a number having a value of 1, 2, or 3. The plurality of first quantum dots 130 may exhibit a higher stability in comparison to a substantially similar composition comprising the first plurality of quantum dots without the first zero dimensional perovskite material. The substantially similar composition may comprise any composition using semiconductor materials for the plurality of first quantum dots 130 without the use of the first zero dimensional perovskite materials (e.g., or any other perovskite material).

The first zero dimensional perovskite material may be defined by $A_nBX_{n+2}$, where A comprises a monovalent cation, B comprises a bivalent cation, X comprises a halogen anion, and n is a number having a value of at least 4. The first zero dimensional perovskite material may comprise a first cation, a second cation, and a halogen anion. The first cation may comprise at least four valence electrons. The first cation may comprise $CH_3NH_3$ or Cs. The second cation may comprise $Pb_2$, $Sn_2$ or $Bi_2$. The halogen anion may comprise Cl, Br or I. The first zero dimensional perovskite material may comprise $Cl_6$, $Br_6$, or $I_6$. The first zero dimensional perovskite material may comprise $(CH_3NH_3)_4$, $Cs_4$, or a combination thereof. The first zero dimensional perovskite material may comprise $Cs_4PbX_6$, where X is Br or I. As an example, the first zero dimensional perovskite material may comprise $Cs_4PbBr_6$. As another example, the first zero dimensional perovskite material may comprise Methyl Ammonium Lead Iodide ($MAPbI_3$).

The plurality of second quantum dots 140 may comprise a second zero dimensional perovskite material. The second zero dimension perovskite material may be the same as the first zero dimensional perovskite material. The second zero dimension perovskite material may have an emission property based on a quantum confinement state. The quantum confinement state may confine a charge carrier to a molecule of the first zero dimensional perovskite material. The second zero dimensional perovskite material may have an emission property based on a quantum confinement state in which electrical overlap between adjacent octahedra is minimized. The electrical overlap between adjacent octahedra may be minimized in comparison to a conventional perovskite material. The conventional perovskite material may comprise octahedra forming one or more of one-dimensional chains, two-dimensional planes, or three-dimensional structures. The conventional perovskite material may be defined by $A_nBX_{n+2}$, where A comprises a monovalent cation, B comprises a bivalent cation, X comprises a halogen anion, and n is a number having a value of 1, 2, or 3. The plurality of second quantum dots 140 may exhibit a higher stability in comparison to a substantially similar composition comprising the plurality of second quantum dots 140 without the first zero dimensional perovskite material. The substantially similar composition may comprise any composition using semiconductor materials for the plurality of second quantum dots 140 without the use of the second zero dimensional perovskite materials (e.g., or any other perovskite material).

The second zero dimensional perovskite material may be defined by $A_nBX_{n+2}$, where A comprises a monovalent cation, B comprises a bivalent cation, X comprises a halogen anion, and n is a number having a value of at least 4. The second zero dimensional perovskite material may comprise a first cation, a second cation, and a halogen anion. The first cation may comprise at least four valence electrons. The first cation may comprise $CH_3NH_3$ or Cs. The second cation may comprise $Pb_2$, $Sn_2$ or $Bi_2$. The halogen anion may comprise Cl, Br or I. The second zero dimensional perovskite material may comprise $Cl_6$, $Br_6$, or $I_6$. The second zero dimensional perovskite material may comprise $(CH_3NH_3)_4$, $Cs_4$, or a combination thereof. The second zero dimensional perovskite material may comprise $Cs_4PbX_6$, where X is Br or I. As an example, the second zero dimensional perovskite material may comprise $Cs_4PbBr_6$. As another example, the second zero dimensional perovskite material may comprise Methyl Ammonium Lead Iodide ($MAPbI_3$).

The plurality of first quantum dots 130 may comprise quantum dots sized from about 2 nanometers (nm) to about 20 nm. The plurality of first quantum dots 130 may comprise red quantum dots with a peak emission wavelength between about 600 nm to about 750 nm. The plurality of second quantum dots 140 may comprise quantum dots sized from about 2 nm to about 20 nm. The plurality of second quantum dots 140 may comprise green quantum dots with a peak emission wavelength between about 490 nm to about 580 nm. In some implementations, the plurality of first quantum dots 130 and/or the plurality of second quantum dots 140 may have a size on the order of magnitude of a micron. For example, the plurality of first quantum dots 130 and/or the plurality of second quantum dots 140 may be from have a size from about 0.1 $\mu$m to about 10 $\mu$m.

One or both of the plurality of first quantum dots 130 and the plurality of second quantum dots 140 may be disposed in at least one polymer layer 110 by way of an extrusion process, a coating process, a printing process, a lithography process, and/or a polymerization process.

The at least one polymer layer 110 may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, liquid crystalline polymer, polyetherimide, polyethylacrylate, or a combination thereof.

The plurality of first quantum dots 130 and the plurality of second quantum dots 140 may be disposed in a quantum dot layer adjacent to a light source. The light source may comprise a blue light emitting source.

The film 100 may optionally comprise texturing 150 on one or both surfaces of the film 100 as illustrated in FIG. 1B. The texturing 150 may provide an optical function. For example, the texturing 150 may comprise a microlens array, a prism, a diffuser, or a combination thereof. The film 100 may comprise a first texture region disposed on a top side of the at least one polymer layer. The first texture region may be configured as a diffuser, a prism, a microlens array, or a combination thereof. The film 100 may comprise a second texture region disposed on a bottom side of the at least one polymer layer. The second texture region may be configured as a diffuser, a prism, a microlens array, or a combination thereof.

In some aspects, the plurality of quantum dots 120 may be thermally stabilized, air stabilized, moisture stabilized and/or flux stabilized. For example, the first perovskite material and the second perovskite material may provide thermal stability, air stability, moisture stability and/or flux stability. Such stability allows the barrier layer(s) (protective layers) found in conventional quantum dot films to be eliminated, resulting in a quantum dot film that has improved optical properties as compared to conventional quantum dot films that include one or more barrier layers. In addition, elimination of the barrier layer(s) allows for formation and use of a thinner quantum dot film. Thinner quantum dot films are more useful in various applications, including display applications as discussed further herein.

In addition to using zero dimensional perovskite material for stability, the plurality of stabilized quantum dots 120 may be further stabilized in any suitable manner. In some aspects, the plurality of stabilized quantum dots 120 may be further stabilized by providing an encapsulation around each of the plurality of quantum dots, the encapsulation including an organic material or an inorganic material. The encapsulation protects the quantum dot from damage in the same manner that a barrier layer(s) would protect the quantum dot layer in a conventional quantum dot film. The plurality of ligands may include any ligand type that will interact (e.g., attach) to the quantum dot. The plurality of ligands protect the quantum dot from damage.

In an aspect, each of the plurality of quantum dots may comprise a multi-shell structure, such as but not limited to a first shell including a first material and at least a second shell including a second material that may be the same or different than the first material. The plurality of quantum dots in these aspects may have a core that is of the same or a different material than the shell or multi-shell structure material(s).

Typically, perovskites have a cubic structure with general formula of ABX3. In this structure, an A-site ion (e.g., on the corners of the lattice) may comprise an alkaline earth or rare-earth element. B-site ions (e.g., on the center of the lattice) may comprise be 3d, 4d, and 5d transition metal elements. Example, alkaline earth elements may comprise one or more of Beryllium (Be), Magnesium (Mg), Calcium (Ca), Strontium (Sr), Barium (Ba), and Radium (Ra). Example rare earth elements may comprise Scandium (Sc), Yttrium (Y), Lanthanum (La), Cerium (Ce), Praseodymium (Pr), Neodymium (Nd), Promethium (Pm), Samarium (Sm), Europium (Eu), Gadolinium (Gd), Terbium (Tb), Dysprosium (Dy), Holmium (Ho), Erbium (Er), Thulium (Tm), Ytterbium (Yb), and Lutetium (Lu). Example 3d transition metals may comprise Scandium (Sc), Titanium (Ti), Vanadium (V), Chromium (Cr), Manganese (Mn), Iron (Fe), Cobalt (Co), Nickel (Ni), Copper (Cu), and Zinc (Zn). Example 4d transition metals may comprise one or more of Yttrium (Y), Zirconium (Zr), Niobium (Nb), Molybdenum (Mo), Technetium (Tc), Ruthenium (Ru), Rhodium (Rh), Palladium (Pd), Silver (Ag), and Cadmium (Cd). Example 5d transition metals may comprise one or more of Lanthanum (La), Hafnium (Hf), Tantalum (Ta), Tungsten (W), Rhenium (Re), Osmium (Os), Iridium (Ir), Platinum (Pt), Gold (Au), and Mercury (Hg). The X in the formula may comprise any appropriate anion, such as an anion that bonds to both A and B. The plurality of stabilized quantum dots 120 may comprise any of the above elements in a combination suitable for forming a zero-dimensional perovskite material.

Exemplary quantum dots according to aspects of the disclosure may include, but are not limited to, semiconductor nanocrystals selected from the group consisting of, but not limited to, Group II-VI semiconductor compounds, Group II-V semiconductor compounds, Group III-VI semiconductor compounds, Group III-V semiconductor compounds, Group IV-VI semiconductor compounds, Group II-III-VI compounds, Group II-IV-VI compounds, Group II-IV-V compounds, alloys thereof and combinations thereof. As another example, the quantum dots may comprise semiconductor nanocrystals comprising or more of Group II elements, Group III elements, Group IV elements, Group V elements, and/or group VI elements.

Exemplary Group II elements include Zn, Cd, Hg or a combination thereof.

Exemplary Group III elements include Al, Ga, In, Ti or a combination thereof.

Exemplary Group IV elements include Si, Ge, Sn, Pb or a combination thereof.

Exemplary Group V elements include P, As, Sb, Bi or a combination thereof.

Exemplary Group VI elements include O, S, Se, Te or a combination thereof.

Where the plurality of quantum dots 220 are described herein as having a shell or a multi-shell structure (i.e., a core and at least one shell), the core and the shell or plurality of shells may independently be formed of the semiconductor materials described above.

The semiconductor nanocrystals may have a multi-layer structure consisting of two or more layers composed of different materials. The multi-layer structure of the semiconductor nanocrystals may include at least one alloy interlayer composed of two or more different materials at the interface between the adjacent layers. In one exemplary aspect, the alloy interlayer may be composed of an alloy having a composition gradient.

In yet other aspects the plurality of quantum dots may comprise quantum dots stabilized by a combination of one or more features.

In some aspects one or more of the plurality of quantum dots 120 may comprise a metal nanomaterial or an inorganic nanomaterial. The form of the plurality of quantum dots 120 may include in certain aspects a nanoparticle, a nanofiber, a nanorod, or a nanowire.

The at least one polymer layer 110 may include any polymer suitable for use in quantum dot films, and may include any thermoplastic polymer capable of being extruded as a polymer layer. Exemplary polymers that may be used in the at least one polymer layer 110 include, but are not limited to, polycarbonate (PC), polyethylene terephthalate (PET), polymethyl methacrylate (PMMA), polyaryletherketones (PAEK), polybutylene terephthalate (PBT), cyclic olefin copolymer (COC), polyethylene naphthalate (PEN), poly(ether sulfone) PES, polyamide (PA), polyphthalamide (PPA), polyimides, polyolefins, polystyrene, and combinations thereof.

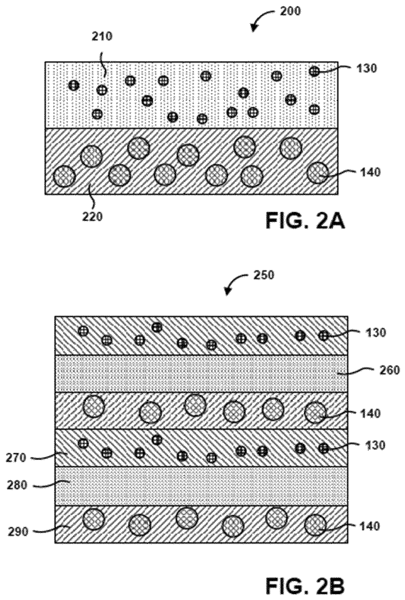

In some aspects, the at least one polymer layer 110 includes a scattering material. Scattering material, which may include but is not limited to metal oxide particles, may be included in the at least one polymer layer 110 to modify the optical properties of the at least one polymer layer 110 as desired. In further aspects, a separate layer including a scattering material (as shown in FIG. 2B) may be included in the quantum dot film 200. Exemplary scattering materials include, but are not limited to, titanium dioxide ($TiO_2$), silicon dioxide ($SiO_2$), aluminum oxide ($Al_2O_3$), zinc oxide (ZnO), zinc peroxide ($ZnO_2$), zirconium dioxide ($ZrO_2$), and combinations thereof. The scattering material in some aspects has a particle size of from about 0.1 micrometer ($\mu$m) to about 10 $\mu$m.

The at least one polymer layer 110 may in particular aspects include one or more optional additional additives, including but not limited to a dispersant, a scavenger, a stabilizer or a combination thereof. In particular, a scavenger may be provided to absorb oxygen and/or moisture, which could help to protect the stabilized quantum dot from damage in the presence thereof. Exemplary scavenger materials include, but are not limited to, oxygen scavengers such as hydrazine, Carbo-Hz, sodium sulfite, n,n-diethylhydroxylamine (DEHA), methylethyl ketone oxime (MEKO), erythorbate, hydroquinone, and combinations thereof, and moisture scavengers such as calcium oxide, magnesium oxide, strontium oxide, barium oxide, aluminum oxide, silicone oxide, and combinations thereof. The scavenger in some aspects has a particle size of from about 0.1 micrometer ($\mu$m) to about 10 $\mu$m.

The at least polymer layer 110 may comprise phosphor materials. For example, at least one polymer layer 110 may comprise an optimal combination of perovskite material and phosphor material for a specified application. The plurality of first quantum dots 130 may comprise red phosphor (e.g., mixed with the first perovskite material) with a peak emission wavelength between about 600 nm to about 750 nm. The plurality of second quantum dots 140 may comprise green phosphor (e.g., mixed with the second perovskite material) with a peak emission wavelength between about 490 nm to about 580 nm.

FIG. 2A illustrates an example multi-layer film 200 in accordance with the present disclosure. The multi-layer film 200 may comprise a first layer 210 comprising the plurality of first quantum dots 130 disposed in a first polymer and that emit light in a first wavelength range upon excitation. The plurality of first quantum dots 130 may comprise a first zero dimensional perovskite material. The first zero dimension perovskite material may have an emission property based on a quantum confinement state. The plurality of first quantum dots 130 may comprise all the aspects described further herein throughout the present disclosure. The first polymer may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, liquid crystalline polymer, polyetherimide, polyethylacrylate, or a combination thereof. The first polymer may comprise any other polymer described herein.

The multi-layer film 200 may comprise a second layer 220. The second layer 220 may comprise the plurality of second quantum dots 140 disposed in a second polymer and that emit light in a second wavelength range upon excitation. The plurality of second quantum dots 140 may comprise a second zero dimensional perovskite material. The plurality of second quantum dots 140 may comprise all the aspects described further herein for the plurality of second quantum dots 140. The second polymer may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, liquid crystalline polymer, polyetherimide, polyethylacrylate, or a combination thereof. The second polymer may comprise any other polymer described herein.

The first layer 210 and/or the second layer 220 may be disposed adjacent to a light source. The light source may comprise a blue light emitting source. The plurality of first quantum dots 130 may be disposed in the first layer by way of an extrusion process, a coating process, a printing process, a lithography process or a polymerization process. The plurality of second quantum dots 140 may be disposed in the second layer by way of an extrusion process, a coating process, a printing process, a lithography process or a polymerization process. As an example, the extrusion process may comprise a multi-layer extrusion process.

FIG. 2B illustrates an example multi-layer film 250 in accordance with the present disclosure. The multi-layer film 250 may comprise a third layer 260 disposed between the first layer 210 and the second layer 220. The third layer 260 may comprise one or more optical enhancement features, such as diffuser, MLA, Prism function, or a combination thereof. For example, a diffuser may be configured to enhance luminance (e.g., brightness of a backlight unit) and/or configured to provide uniformity in brightness (e.g., of the backlight unit). The third layer 260 may comprise a polymer (e.g., including of the polymer disclosed herein). In an aspect, the multi-layer film 250 may comprise additional layers, such as a fourth layer 270 comprising the plurality of first quantum dots, a fifth layer 280 (e.g., comprising the optical enhancement features, or other features), and a sixth layer 290 comprise the plurality of second quantum dots. In some implementations, the additional layers may be omitted.

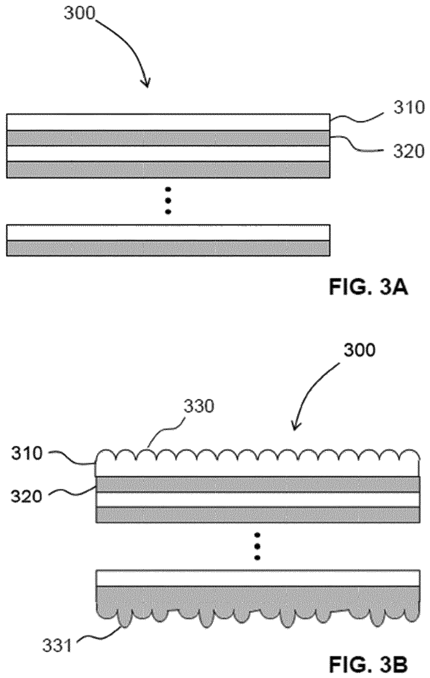

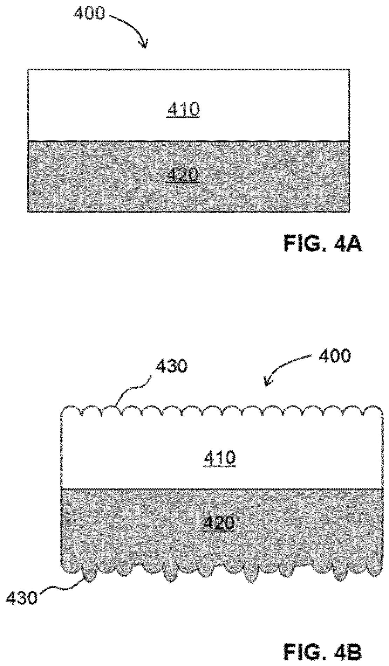

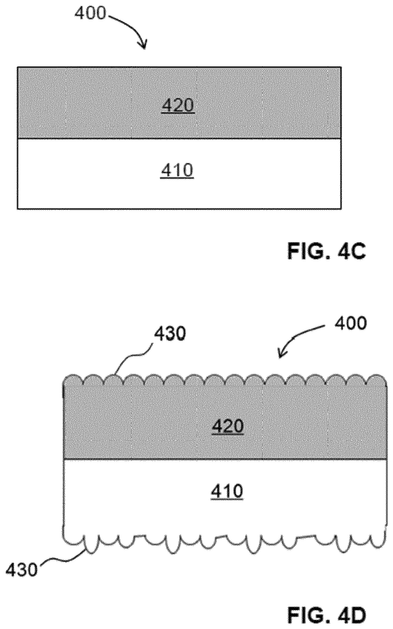

With reference to FIG. 3A and FIG. 3B, in some aspects the multi-layer film 300 (e.g., quantum dot film) may comprise a plurality of polymer layers 310, 320 (e.g., extruded polymer layers). Each of the plurality of polymer layers 310, 320 may comprise a plurality of quantum dots as described above. The plurality of quantum dots in each of the plurality of polymer layers 310, 320 may emit light having the same wavelength(s) as those in other of the extruded polymer layers or in some aspects each of the plurality of polymer layers 310, 320 may include different types of stabilized quantum dots such that the quantum dots in one polymer layer (e.g., 310) emit light having a wavelength that is different than the wavelength of light emitted by the quantum dots in another extruded polymer layer (e.g., 320). Thus, for example, one or more of the polymer layers 310 may include quantum dots that emit green light, and one or more other polymer layers 320 may include quantum dots that emit red light. The sequence of layers (e.g., whether the layer has quantum dots that emit green light or red light) may vary and depend on the specifications for a particular implementation. For example, a top polymer layer 310 (e.g., or 410 of FIG. 4) may comprise quantum dots that emit green light and a lower (e.g., or bottom) polymer layer 320 (e.g., or 420 of FIG. 4) may comprise quantum dots that emit red light. As another example, the top polymer layer 310 may comprise quantum dots that emit red light and the lower (e.g., or bottom) polymer layer 320 may comprise quantum dots that emit green light. The plurality of polymer layers may have varying levels of thickness. For example, the top polymer layer 310 (e.g., or 410 of FIG. 4) may be thicker than the bottom polymer layer 320 (e.g., or 420 of FIG. 4). The top polymer layer 310 may be less thick than the bottom polymer layer 320. The thickness, number, and order of the layers may depend on the design specifications of a particular application. The thickness of quantum dot layers may range from 1 micrometers (micron, μm) to 10,000 μm. For example, the quantum dot layer may have a thickness of about 100 μm. As another example, a quantum dot film thickness (e.g., including base substrate of about 100 μm and bottom and top side barrier films together having a thickness of about 100 to about 200 μm) may range from about 250 μm to 400 μm in a large size display application. Quantum dot layer thickness may be from about 1 μm to 100 μm for a display application. Quantum dot layer thickness may be from 1 μm to 10,000 μm for lighting application.

As illustrated in FIG. 3B, one or more of the plurality of polymer layers may include texturing 330, 331 for modifying the optical properties of the quantum dot film 300, as desired. For example, the multi-layer film 300 may comprise a first texture region 330 disposed on a top side of a polymer layer and/or a topside of the multi-layer film 300. The first texture region 330 may be configured as a diffuser, a prism, a microlens array, or a combination thereof. The multi-layer film 300 may comprise a second texture region 331 disposed on a bottom side of a polymer layer and/or a bottom side of the multi-layer film 300. The second texture region 331 may be configured as a diffuser, a prism, a microlens array, or a combination thereof.

Other aspects of a multi-layer quantum dot film 400 are illustrated in FIGs. 4A-4D, including a plurality of polymer layers 410, 420 (e.g., extruded polymer layers) with optional texturing 430 on one or more surfaces of the polymer layers 410, 420. The plurality of quantum dots (e.g., comprising the zero-dimensional perovskite material) in each of the plurality of polymer layers 410, 420 may emit light having the same wavelength(s) as those in other of the polymer layers or in some aspects each of the plurality of polymer layers 410, 420 may include different types of quantum dots such that the quantum dots in one polymer layer (e.g., 410) emit light having a wavelength that is different than the wavelength of light emitted by the quantum dots in another polymer layer (e.g., 420). Thus, for example, one or more of the polymer layers 410 may include quantum dots that emit green light, and one or more other polymer layers 420 may include quantum dots that emit red light.

In particular aspects the quantum dot film includes at least two polymer layers 310, 320, 410, 420, (e.g., extruded polymer layers) wherein substantially all of the quantum dots in one of the polymer layers emits light having a first wavelength, and substantially all of the stabilized quantum dots in another of the polymer layers emits light having a second wavelength, and wherein the first wavelength is different than the second wavelength. As used herein, "substantially all of the stabilized quantum dots" means that (1) all of the stabilized quantum dots in the respective polymer layer emit light having the first/second wavelength, or (2) a significant portion of the stabilized quantum dots in the respective polymer layer emit light having the first/second wavelength such that the light emitted from the stabilized quantum dots satisfies color standards for light at the respective wavelength.

Separation of different types of quantum dots (e.g., those that emit light having different colors) in polymer layers 310, 320, 410, 420 as shown in FIGS. 3A-4D allows for an increase in quantum efficiency of the quantum dot film 300, 400. Quantum dots that emit light at different wavelengths are susceptible to a phenomenon called Förster Resonance Energy Transfer (FRET), also referred to as fluorescence resonance energy transfer, in which non-radiative energy is transferred from a fluorescent donor (e.g., a quantum dot emitting light at a higher energy) to a lower energy acceptor (e.g., a quantum dot emitting light at a lower energy) through long-range dipole-dipole interactions. FRET can occur if two particles (e.g., quantum dots) are within about 20 nm of each other. In aspects of the present disclosure, FRET between quantum dots that emit light at different colors (e.g., red and green) is avoided by locating quantum dots that emit light at one color in one extruded polymer layer 310, 410 and locating quantum dots that emit light at a different color in another extruded polymer layer 320, 420.

The plurality of polymer layers described herein may be extruded in any suitable process. Examples include, but are not limited to, a co-extrusion process and a multi-layer extrusion (MLE) process.

In some aspects, the quantum dot film 100, 200, 250, 300, 400 does not include a barrier layer such as those found in conventional quantum dot films. As a result, the quantum dot film 100, 200, 250, 300, 400 may be made with fewer processes, and thinner quantum dot films can be made. These improvements reduce the cost of the quantum dot film and enhance the optical properties of the quantum dot film. In particular, in the case of quantum dot films including a plurality of extruded polymer layers, the plurality of extruded polymer layers may be seamless (in contrast to conventional quantum dot films including one or more barrier layers), which further enhances the optical properties of the quantum dot film because light emitted by the stabilized quantum dots is not affected as it travels from one extruded polymer layer to the other.

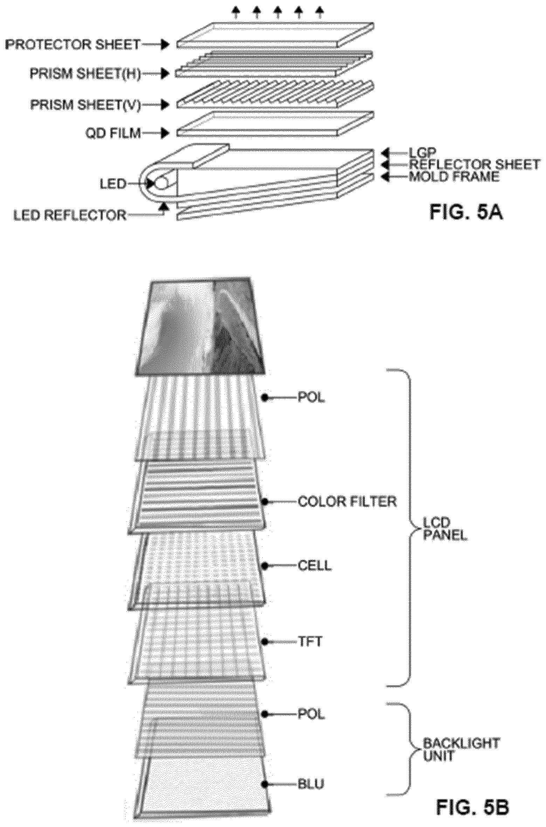

The quantum dot layer 302 may be disposed adjacent to a light source (e.g., as shown in FIG. 5A). The light source may comprise a blue light emitting source. For example, the blue light source may emit light in a range from 440 nm to 460 nm. The blue light source may have a Full Width, Half Max (FWHM) of less than 25 nm. The film may be a part of an optical device comprising an LCD panel having a native color gamut in a range from 35% to 45% NTSC, and one or more QD layers (as described herein) positioned or optically between the blue light source and the LCD panel.

The optical construction may achieve a color gamut of at least 50% NTSC in some aspects.

In further examples, the composition of the first polymer and/or the second polymer may also be tailored to provide improved compatibility between the polymer and the surface chemistry of the plurality of first quantum dots and/or the plurality of second quantum dots. Accordingly, layers of the film may comprise a polymer (e.g., polymer matrix), a plurality of particular quantum dots, and in some aspects one or more compatibilizing additives. These additives may make the polymer more compatible with the QD. In further examples, the first polymer may be selected to be compatible to a ligand encapsulating the plurality of first quantum dots and the second polymer matrix may be selected to be compatible to a ligand encapsulating the plurality of second quantum dots. In another aspect, the ligand encapsulating the plurality of first quantum dots may be compatible (e.g., or may be selected to be compatible) with the first polymer. The ligand encapsulating the plurality of second quantum dots may be compatible (e.g., or may be selected to be compatible) with the second polymer.

The quantum dot layers described herein may have any useful amount of quantum dots. In many embodiments the quantum dot layer can have from about 0.001 wt% to about 10 wt% quantum dots or from about 0.05 to about 5 wt. % quantum dots. It is understood that various intervening endpoints in the proposed size ranges may be used. However, other loadings of quantum dots may be used.

FIG. 5A shows an example backlight structure in which the present film may be integrated. The backlight structure may be configured to emit electromagnetic radiation as part of an optical structure, such as an LCD panel. The backlight structure may comprise a reflector sheet, a mold frame, an LGP, and an LED reflector. The backlight structure may comprise a quantum dot layer, a horizontal prism layer, a vertical prism layer, a protector sheet, and/or the like.

FIG. 5B shows an example optical device in which the present film may be integrated. The optical device may comprise the backlight structure of FIG. 5A. For example, the optical device may comprise one or more layers of an LCD panel disposed above the backlight structure. The optical device may comprise a bottom polarizer, a thin film transistor (TFT), a cell layer, a color filter layer, a top polarizer, and/or the like.

## Method of Making

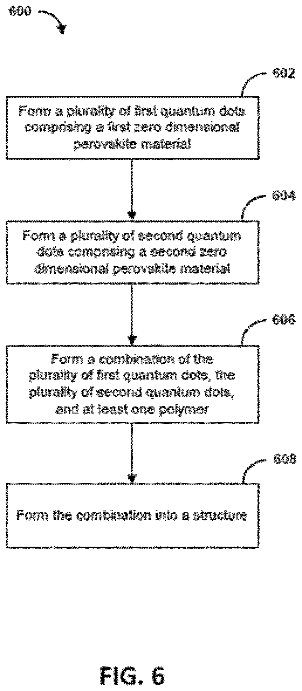

FIG. 6 is a flowchart illustrating an example method in according with the present disclosure. At step 602, a plurality of first quantum dots may be formed. The plurality of first quantum dots may comprise any of the features described herein, such as the features of the plurality of first quantum dots 130 of FIG. 1. The plurality of first quantum dots may emit light in a first wavelength range upon excitation. The plurality of first quantum dots may comprise a first zero dimensional perovskite material. The first zero dimension perovskite material may have an emission property based on a quantum confinement state. The electrical overlap between adjacent octahedra may be minimized in comparison to a conventional perovskite material. For example, the first zero dimensional perovskite material may comprise an octahedra structure having localized electron states isolated from other octahedra structures of the first zero dimensional perovskite material. The conventional perovskite material may comprise octahedra forming one or more of one-dimensional chains, two-dimensional planes, or three-dimensional structures. The conventional perovskite material may be defined by $A_nBX_{n+2}$, where A comprises a monovalent cation, B comprises a bivalent cation, X comprises a halogen anion, and n is a number having a value of 1, 2, or 3. The plurality of first quantum dots 130 may exhibit a higher stability in comparison to a substantially similar composition comprising the first plurality of quantum dots without the first zero dimensional perovskite material. The substantially similar composition may comprise any composition using semiconductor materials for the plurality of first quantum dots 130 without the use of the first zero dimensional perovskite materials (e.g., or any other perovskite material).

The first zero dimensional perovskite material may be defined by $A_nBX_{n+2}$, where A comprises a monovalent cation, B comprises a bivalent cation, X comprises a halogen anion, and n is a number having a value of at least 4. The first zero dimensional perovskite material may comprise a first cation, a second cation, and a halogen anion. The first cation may comprise at least four valence electrons. The first cation may comprise $CH_3NH_3$ or Cs. The second cation may comprise $Pb_2$, $Sn_2$ or $Bi_2$. The halogen anion may comprise Cl, Br or I. The first zero dimensional perovskite material may comprise $Cl_6$, $Br_6$, or $I_6$.. The first zero dimensional perovskite material may comprise $(CH_3NH_3)_4$, $Cs_4$, or a combination thereof. The first zero dimensional perovskite material may comprise $Cs_4PbX_6$, where X is Br or I.

At step 604, a plurality of second quantum dots that may be formed. The plurality of second quantum dots may comprise any of the features described herein, such as the features of the plurality of second quantum dots 140 of FIG. 1. For example, the plurality of second quantum dots may emit light in a second wavelength range upon excitation. The plurality of second quantum dots may comprise a second zero dimensional perovskite material. The second zero dimension perovskite material may have an emission property based on a quantum confinement state. The quantum confinement state may confine a charge carrier to a molecule of the first zero dimensional perovskite material. The second zero dimensional perovskite material may have an emission property based on a quantum confinement state in which electrical overlap between adjacent octahedra is minimized. The electrical overlap between adjacent octahedra may be minimized in comparison to a conventional perovskite material. The conventional perovskite material may comprise octahedra forming one or more of one-dimensional chains, two-dimensional planes, or three-dimensional structures. The conventional perovskite material may be defined by $A_nBX_{n+2}$, where A comprises a monovalent cation, B comprises a bivalent cation, X comprises a halogen anion, and n is a number having a value of 1, 2, or 3. The plurality of second quantum dots 140 may exhibit a higher stability in comparison to a substantially similar composition comprising the plurality of second quantum dots 140 without the first zero dimensional perovskite material. The substantially similar composition may comprise any composition using semiconductor materials for the plurality of second quantum dots 140 without the use of the second zero dimensional perovskite materials (e.g., or any other perovskite material).

The second zero dimensional perovskite material may be defined by $A_nBX_{n+2}$, where A comprises a monovalent cation, B comprises a bivalent cation, X comprises a halogen anion, and n is a number having a value of at least 4. The second zero dimensional perovskite material may comprise a first cation, a second cation, and a halogen anion. The first cation may comprise at least four valence electrons. The first cation may comprise $CH_3NH_3$ or Cs. The second cation may comprise $Pb_2$, $Sn_2$ or $Bi_2$. The halogen anion may comprise Cl, Br or I. The second zero dimensional perovskite material may comprise $Cl_6$, $Br_6$, or $I_6$. The second zero dimensional perovskite material may comprise $(CH_3NH_3)_4$, $Cs_4$, or a combination thereof. The second zero dimensional perovskite material may comprise $Cs_4PbX_6$, where X is Br or I.

At step 606, a combination of the plurality of first quantum dots, the plurality of second quantum dots, and at least one polymer may be formed. The at least one polymer may comprise a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

At step 608, the combination may be formed into a structure. In some scenarios step 608 and step 606 may occur at least partially at the same time. Forming the combination into a structure may comprise forming a pellet, a film, or an injection molded structure. As an example, forming the combination into a structure may comprise extruding the combination to form a single layer film comprising the plurality of first quantum dots and the plurality of second quantum dots. As another example, forming the combination into a structure may comprise extruding the combination to form a multi-layer film. The multi-layer film may comprise a first layer comprising the plurality of first quantum dots. The multi-layer film may comprise a second layer comprising the plurality of second quantum dots.

In an aspect, forming the combination into a structure may comprise forming a first texture region disposed on a top side of a layer. The first texture region may be configured as a diffuser, a prism, a microlens array, or a combination thereof. Forming the combination into a structure may comprise forming a second texture region disposed on a bottom side of a layer. The second texture region may be configured as a diffuser, a prism, a microlens array, or a combination thereof.

In an aspect, the structure, may comprise a film, or one or more layers of a film. The combination may be disposed in one or more layers by way of an extrusion process, a coating process, a printing process, a lithography process or a polymerization process.

As an illustration, one or more layers (e.g., the at least one polymer layer 110, the first layer 210, the second layer 220, the third layer 260, the fourth layer 270, the fifth layer 280, the sixth layer 280) may be formed by an extrusion process. This approach is in contrast to conventional quantum dot films that cannot be extruded because the quantum dots used in conventional quantum dot films would be damaged or destroyed by the thermal and mechanical stresses that are inherent to the extrusion process (e.g., co-extrusion, multi-layer extrusion). The use of quantum dots comprising zero-dimensional quantum dots in aspects of the disclosure enable extrusion processes for making the quantum dot films described herein. Extrusion offers a low-cost method for making high performance quantum dot films.

In such an extrusion process the one or any foregoing components described herein (including the quantum dots comprising zero-dimensional perovskite material) may first be dry blended together, then fed into an extruder from one or multi-feeders, or separately fed into an extruder from one or multi-feeders. The one or any foregoing components may be first dry blended with each other, or dry blended with any combination of foregoing components, then fed into an extruder from one or multi-feeders, or separately fed into an extruder from one or multi-feeders. The components may be fed into the extruder from a throat hopper or any side feeders.

In some aspects one or any foregoing components described herein (including the quantum dots comprising zero-dimensional perovskite material) may, prior to extrusion, be prepared as a quantum dot formulation, or quantum dot "ink." The quantum dot formulation may include the quantum dot particles (e.g., zero dimensional perovskite material, phosphor) and optional components including but not limited to a scattering material, a dispersant, a binder, a scavenger, a stabilizer and a combination thereof. The quantum dot formulation could be added to polymer and then fed into the extruder as described herein.

The extruders may have a single screw, multiple screws, intermeshing co-rotating or counter rotating screws, non-intermeshing co-rotating or counter rotating screws, reciprocating screws, conical screws, screws with pins, screws with screens, barrels with pins, rolls, rams, helical rotors, co-kneaders, disc-pack processors, various other types of extrusion equipment, or combinations comprising at least one of the foregoing.

The barrel temperature on the extruder during compounding can be set at the temperature where at least a portion of the polymer in the at least one extruded polymer layer has reached a temperature greater than or equal to about the melting temperature, if the polymer is a semi-crystalline organic polymer, or the flow point (e.g., the glass transition temperature) if the polymer is an amorphous polymer.

The mixture including the foregoing mentioned components may be subject to multiple blending and forming steps if desirable. For example, the composition may first be extruded and formed into pellets. The pellets may then be fed into a molding machine where it may be formed into any desirable shape or product. Alternatively, the composition emanating from a single melt blender may be formed into sheets or strands and subjected to post-extrusion processes such as annealing, uniaxial or biaxial orientation.

The temperature of the melt in the present process may in some aspects be maintained as low as possible in order to avoid excessive degradation of the components (e.g., the polymer in the at least one extruded polymer layer). In certain aspects, the melt temperature may be maintained between about 180°C and about 350°C. In some aspects, the melt processed composition exits processing equipment, such as an extruder, through small exit holes in a die. The resulting strands of molten resin may be cooled by passing the strands through a water bath. The cooled strands can be chopped into small pellets for packaging and further handling.

The present disclosure relates to at least the following aspects.

Aspect 1. A film comprising: a polymer layer; a plurality of first quantum dots disposed in the polymer layer and that emit light in a first wavelength range upon excitation, wherein the plurality of first quantum dots comprise a first zero dimensional perovskite material, wherein the first zero dimension perovskite material has an emission property based on a quantum confinement state; and a plurality of second quantum dots disposed in the polymer layer and that emit light in a second wavelength range upon excitation, wherein the plurality of second quantum dots comprise a second zero dimensional perovskite material.

Aspect 2. The film of aspect 1, wherein electrical overlap between adjacent octahedra of first zero dimensional perovskite material is minimized in the quantum confinement state.

Aspect 3. The film of aspect 2, wherein the electrical overlap between adjacent octahedra is minimized in comparison to a conventional perovskite material, and wherein the conventional perovskite material is defined by $A_nBX_{n+2}$, wherein A comprises a monovalent cation, B comprises a bivalent cation, X comprises a halogen anion, and n is a number having a value of 1, 2, or 3.

Aspect 4. The film of any one of aspects 1-3, wherein the second zero dimensional perovskite material has an emission property based on a quantum confinement state in which electrical overlap between adjacent octahedra is minimized in comparison to a conventional perovskite material, wherein the conventional perovskite material comprises octahedra forming one or more of one-dimensional chains, two-dimensional planes, or three-dimensional structures.

Aspect 5. The film of any one of aspects 1-4, wherein the plurality of first quantum dots disposed in the polymer layer exhibit a higher stability in comparison to a substantially similar composition comprising the first plurality of quantum dots without the first zero dimensional perovskite material.

Aspect 6. The film of any one of aspects 1-5, wherein the plurality of second quantum dots disposed in the polymer layer exhibit a higher stability in comparison to a substantially similar composition comprising the plurality of second quantum dots without the first zero dimensional perovskite material.

Aspect 7. The film of any one of aspects 1-6, wherein first zero dimensional perovskite material has a quantum confinement state confining a charge carrier to a molecule of the first zero dimensional perovskite material.

Aspect 8. The film of any one of aspects 1-7, wherein the first zero dimensional perovskite material comprises an octahedra structure having localized electron states isolated from other octahedra structures of the first zero dimensional perovskite material.

Aspect 9. The film of any one of aspects 1-8, wherein the first zero dimensional perovskite material is defined by $A_nBX_{n+2}$, wherein A comprises a monovalent cation, B comprises a bivalent cation, X comprises a halogen anion, and n is a number having a value of at least 4.

Aspect 10. The film of any one of aspects 1-9, wherein the first zero dimensional perovskite material comprises a first cation, a second cation, and a halogen anion, wherein the first cation comprises at least four valence electrons.

Aspect 11. The film of aspect 10, wherein the first cation comprises $CH_3NH_3$ or Cs, the second cation comprises $Pb_2$, $Sn_2$ or $Bi_2$, and the halogen anion comprises Cl, Br or I.

Aspect 12. The film of any one of aspects 1-11, wherein the first zero dimensional perovskite material comprises $Cl_6$, $Br_6$, or $I_6$.

Aspect 13. The film of any one of aspects 1-12, wherein the first zero dimensional perovskite material comprises $(CH_3NH_3)_4$, $Cs_4$, or a combination thereof.

Aspect 14. The film of any one of aspects 1-13, wherein the first zero dimensional perovskite material comprises $Cs_4PbX_6$, where X is Br or I.

Aspect 15. The film of any one of aspects 1-14, further comprising a first texture region disposed on a top side of the polymer layer.

Aspect 16. The film of aspect 15, wherein the first texture region is configured as a diffuser, a prism, a microlens array, or a combination thereof.

Aspect 17. The film of any one of aspects 1-16, further comprising a second texture region disposed on a bottom side of the polymer layer.

Aspect 18. The film of aspect 17, wherein the second texture region is configured as a diffuser, a prism, a microlens array, or a combination thereof.

Aspect 19. The film of any one of aspects 1-18, wherein the plurality of first quantum dots and the plurality of second quantum dots are disposed in a quantum dot layer adjacent to a light source, and wherein the light source comprises a blue light emitting source.

Aspect 20. The film of any one of aspects 1-19, wherein the plurality of first quantum dots comprise quantum dots sized from about 2 nanometers (nm) to about 20 nm.

Aspect 21. The film of any one of aspects 1-20, wherein the plurality of first quantum dots may have a peak emission wavelength between about 600 nm to about 750 nm.

Aspect 22. The film of any one of aspects 1-21, wherein the plurality of second quantum dots comprise quantum dots sized from about 2 nm to about 20 nm.

Aspect 23. The film of any one of aspects 1-22, wherein the plurality of second quantum dots may have a peak emission wavelength between about 490 nm to about 580 nm.

Aspect 24. The film of any one of aspects 1-23, wherein one or both of the plurality of first quantum dots and the plurality of second quantum dots are disposed in a quantum dot layer by way of an extrusion process, a coating process, a printing process, a lithography process or a polymerization process.

Aspect 25. The film of any one of aspects 1-24, wherein the polymer layer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 26. A multi-layer film comprising: a first layer comprising a plurality of first quantum dots disposed in a first polymer and that emit light in a first wavelength range upon excitation, wherein the plurality of first quantum dots comprise a first zero dimensional perovskite material, wherein the first zero dimension perovskite material has an emission property based on a quantum confinement state; and a second layer comprising a plurality of second quantum dots disposed in a second polymer and that emit light in a second wavelength range upon excitation, wherein the plurality of second quantum dots comprise a second zero dimensional perovskite material.

Aspect 27. The multi-layer film of aspect 26, wherein electrical overlap between adjacent octahedra of first zero dimensional perovskite material is minimized in the quantum confinement state.

Aspect 28. The multi-layer film of aspect 27, wherein the electrical overlap between adjacent octahedra is minimized in comparison to a conventional perovskite material, and wherein the conventional perovskite material is defined by $A_nBX_{n+2}$, wherein A comprises a monovalent cation, B comprises a bivalent cation, X comprises a halogen anion, and n is a number having a value of 1, 2, or 3.

Aspect 29. The multi-layer film of any one of aspects 26-28, wherein the second zero dimensional perovskite material has an emission property based on a quantum confinement state in which electrical overlap between adjacent octahedra is minimized in comparison to a conventional perovskite material, wherein the conventional perovskite material comprises octahedra forming one or more of one-dimensional chains, two-dimensional planes, or three-dimensional structures.

Aspect 30. The multi-layer film of any one of aspects 26-29, wherein the plurality of first quantum dots disposed in the first layer exhibit a higher stability in comparison to a substantially similar composition comprising the first plurality of quantum dots without the first zero dimensional perovskite material.

Aspect 31. The multi-layer film of any one of aspects 26-30, wherein the plurality of second quantum dots disposed in the second layer exhibit a higher stability in comparison to a substantially similar composition comprising the plurality of second quantum dots without the first zero dimensional perovskite material.

Aspect 32. The multi-layer film of any one of aspects 26-31, further comprising a third layer comprising the plurality of first quantum dots and a fourth layer comprising the plurality of second quantum dots, wherein the third layer and the fourth layer are disposed between the first layer and second layer.

Aspect 33. The multi-layer film of any one of aspects 26-32, further comprising a fifth layer disposed between the first layer and the second layer, wherein the fifth layer comprises a polymer and one or more optical enhancement features.

Aspect 34. The multi-layer film of any one of aspects 26-33, wherein the first zero dimensional perovskite material has a quantum confinement state confining a charge carrier to a molecule of the first zero dimensional perovskite material.

Aspect 35. The multi-layer film of any one of aspects 26-34, wherein the first zero dimensional perovskite material comprises an octahedra structure having localized electron states isolated from other octahedra structures of the first zero dimensional perovskite material.

Aspect 36. The multi-layer film of any one of aspects 26-35, wherein the first zero dimensional perovskite material is defined by $A_nBX_{n+2}$, wherein A comprises a monovalent cation, B comprises a bivalent cation, X comprises a halogen anion, and n is a number having a value of at least 4.

Aspect 37. The multi-layer film of any one of aspects 26-36, wherein the first zero dimensional perovskite material comprises a first cation, a second cation, and a halogen anion, wherein the first cation comprises at least four valence electrons.

Aspect 38. The multi-layer film of aspects 37, wherein the first cation comprises $CH_3NH_3$ or Cs, the second cation comprises $Pb_2$, $Sn_2$ or $Bi_2$, and the halogen anion comprises Cl, Br or I.

Aspect 39. The multi-layer film of any one of aspects 26-38, wherein the first zero dimensional perovskite material comprises $Cl_6$, $Br_6$, or $I_6$.

Aspect 40. The multi-layer film of any one of aspects 26-39, wherein the first zero dimensional perovskite material comprises $(CH_3NH_3)_4$, $Cs_4$, or a combination thereof.

Aspect 41. The multi-layer film of any one of aspects 26-40, wherein the first zero dimensional perovskite material comprises $Cs_4PbX_6$, where X is Br or I.

Aspect 42. The multi-layer film of any one of aspects 26-41, further comprising a first texture region disposed on a top side of one or more of the first layer or the second layer.

Aspect 43. The multi-layer film of aspect 42, wherein the first texture region is configured as a diffuser, a prism, a microlens array, or a combination thereof.

Aspect 44. The multi-layer film of any one of aspects 26-43, further comprising a second texture region disposed on a bottom side of one or more of the first layer or the second layer.

Aspect 45. The multi-layer film of aspect 44, wherein the second texture region is configured as a diffuser, a prism, a microlens array, or a combination thereof.

Aspect 46. The multi-layer film of any one of aspects 26-45, wherein the plurality of first quantum dots and the plurality of second quantum dots are disposed in a quantum dot layer adjacent to a light source, and wherein the light source comprises a blue light emitting source.

Aspect 47. The multi-layer film of any one of aspects 26-46, wherein the plurality of first quantum dots comprise quantum dots sized from about 2 nanometers (nm) to about 20 nm.

Aspect 48. The multi-layer film of any one of aspects 26-47, wherein the plurality of first quantum dots have a peak emission wavelength between about 600 nm to about 750 nm.

Aspect 49. The multi-layer film of any one of aspects 26-48, wherein the plurality of second quantum dots comprise quantum dots sized from about 2 nm to about 20 nm.

Aspect 50. The multi-layer film of any one of aspects 26-49, wherein the plurality of second quantum dots may have a peak emission wavelength between about 490 nm to about 580 nm.

Aspect 51. The multi-layer film of any one of aspects 26-50, wherein the plurality of first quantum dots are disposed the first layer by way of one or more of an extrusion process, a coating process, a printing process, a lithography process, or a polymerization process, and wherein the plurality of second quantum dots are disposed the second layer by way of one or more of an extrusion process, a coating process, a printing process, a lithography process, or a polymerization process.

Aspect 52. The multi-layer film of any one of aspects 26-51, wherein the polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Aspect 53. A method comprising: forming a plurality of first quantum dots that emit light in a first wavelength range upon excitation, wherein the plurality of first quantum dots comprise a first zero dimensional perovskite material, wherein the first zero dimension perovskite material has an emission property based on a quantum confinement state; forming a plurality of second quantum dots that emit light in a second wavelength range upon excitation, wherein the plurality of second quantum dots comprise a second zero dimensional perovskite material; forming a combination of the plurality of first quantum dots, the plurality of second quantum dots, and at least one polymer; and forming the combination into a structure.

Aspect 54. The method of aspect 53, wherein electrical overlap between adjacent octahedra of the first zero dimensional perovskite material is minimized in the quantum confinement state.

Aspect 55. The method of aspect 54, wherein the electrical overlap between adjacent octahedra is minimized in comparison to a conventional perovskite material, and wherein the conventional perovskite material is defined by $A_nBX_{n+2}$, wherein A comprises a monovalent cation, B comprises a bivalent cation, X comprises a halogen anion, and n is a number having a value of 1, 2, or 3.

Aspect 56. The method of any one of aspects 53-55, wherein the second zero dimensional perovskite material has an emission property based on a quantum confinement state in which electrical overlap between adjacent octahedra is minimized in comparison to a conventional perovskite material, wherein the conventional perovskite material comprises octahedra forming one or more of one-dimensional chains, two-dimensional planes, or three-dimensional structures.

Aspect 57. The method of any one of aspects 53-56, wherein the plurality of first quantum dots exhibit a higher stability in comparison to a substantially similar composition comprising the first plurality of quantum dots without the first zero dimensional perovskite material.

Aspect 58. The method of any one of aspects 53-57, wherein the plurality of second quantum dots exhibit a higher stability in comparison to a substantially similar composition comprising the plurality of second quantum dots without the first zero dimensional perovskite material.

Aspect 59. The method of any one of aspects 53-58, wherein forming the combination into a structure comprises forming a pellet, a film, or an injection molded structure.

Aspect 60. The method of any one of aspects 53-59, wherein forming the combination into a structure comprises extruding the combination to form a single layer film comprising the plurality of first quantum dots and the plurality of second quantum dots.

Aspect 61. The method of any one of aspects 53-60, wherein forming the combination into a structure comprises extruding the combination to form a multi-layer film, wherein the multi-layer film comprises a first layer comprising the plurality of first quantum dots, and wherein the multi-layer film comprises a second layer comprising the plurality of second quantum dots.

Aspect 62. The method of any one of aspects 53-61, wherein the first zero dimensional perovskite material has a quantum confinement state confining a charge carrier to a molecule of the first zero dimensional perovskite material.

Aspect 63. The method of any one of aspects 53-62, wherein the first zero dimensional perovskite material comprises an octahedra structure having localized electron states isolated from other octahedra structures of the first zero dimensional perovskite material.

Aspect 64. The method of any one of aspects 53-63, wherein the first zero dimensional perovskite material is defined by $A_nBX_{n+2}$, wherein A comprises a monovalent cation, B comprises a bivalent cation, X comprises a halogen anion, and n is a number having a value of at least 4.

Aspect 65. The method of any one of aspects 53-64, wherein the first zero dimensional perovskite material comprises a first cation, a second cation, and a halogen anion, wherein the first cation comprises at least four valence electrons.

Aspect 66. The method of aspect 65, wherein the first cation comprises $CH_3NH_3$ or Cs, the second cation comprises $Pb_2$, $Sn_2$ or $Bi_2$, and the halogen anion comprises Cl, Br or I.

Aspect 67. The method of any one of aspects 53-66, wherein the first zero dimensional perovskite material comprises $Cl_6$, $Br_6$, or $I_6$.

Aspect 68. The method of any one of aspects 53-67, wherein the first zero dimensional perovskite material comprises $(CH_3NH_3)_4$, $Cs_4$, or a combination thereof.

Aspect 69. The method of any one of aspects 53-68, wherein the first zero dimensional perovskite material comprises $Cs_4PbX_6$, where X is Br or I.

Aspect 70. The method of any one of aspects 53-69, wherein forming the combination into a structure comprises forming a first texture region disposed on a top side of a layer.

Aspect 71. The method of aspect 70, wherein the first texture region is configured as a diffuser, a prism, a microlens array, or a combination thereof.

Aspect 72. The method of any one of aspects 53-71, wherein forming the combination into a structure comprises forming a second texture region disposed on a bottom side of a layer.

Aspect 73. The method of claim 72, wherein the second texture region is configured as a diffuser, a prism, a microlens array, or a combination thereof.

Aspect 74. The method of any one of aspects 53-73, wherein the plurality of first quantum dots and the plurality of second quantum dots are disposed in a quantum dot layer adjacent to a light source, and wherein the light source comprises a blue light emitting source.

Aspect 75. The method of any one of aspects 53-74, wherein the plurality of first quantum dots comprise quantum dots sized from about 2 nanometers (nm) to about 20 nm.

Aspect 76. The method of any one of aspects 53-75, wherein the plurality of first quantum dots may have a peak emission wavelength between about 600 nm to about 750 nm.

Aspect 77. The method of any one of aspects 53-76, wherein the plurality of second quantum dots comprise quantum dots sized from about 2 nm to about 20 nm.

Aspect 78. The method of any one of aspects 53-77, wherein the plurality of second quantum dots may have a peak emission wavelength between about 490 nm to about 580 nm.

Aspect 79. The method of any one of aspects 53-78, wherein one or both of the plurality of first quantum dots and the plurality of second quantum dots are disposed in a quantum dot layer by way of an extrusion process, a coating process, a printing process, a lithography process or a polymerization process.

Aspect 80. The method of any one of aspects 53-79, wherein the polymer comprises a styrenic, polyvinylchloride, an acrylic, polyethylene, polypropylene, polyamide, thermoplastic polyester, polycarbonate, polyoxymethylene, polyphenylene ether, polysulfone, polyacrylic ester, polyarylamide, polyphenylene sulfide, Liquid crystalline polymer, polyetherimide, polyethylacrylate, or a combination thereof.

Definitions

It is to be understood that the terminology used herein is for the purpose of describing particular aspects only and is not intended to be limiting. As used in the specification and in the claims, the term "comprising" can include the embodiments "consisting of" and "consisting essentially of." Unless defined otherwise, all technical and scientific terms used herein have the same meaning as commonly understood by one of ordinary skill in the art to which this disclosure belongs. In this specification and in the claims which follow, reference will be made to a number of terms which shall be defined herein.

Throughout this document, values expressed in a range format should be interpreted in a flexible manner to include not only the numerical values explicitly recited as the limits of the range, but also to include all the individual numerical values or sub-ranges encompassed within that range as if each numerical value and sub-range is explicitly recited. For example, a range of "about 0.1% to about 5%" or "about 0.1% to 5%" should be interpreted to include not just about 0.1% to about 5%, but also the individual values (e.g., 1%, 2%, 3%, and 4%) and the sub-ranges (e.g., 0.1% to 0.5%, 1.1% to 2.2%, 3.3% to 4.4%) within the indicated range. The statement "about X to Y" has the same meaning as "about X to about Y," unless indicated otherwise. Likewise, the statement "about X, Y, or about Z" has the same meaning as "about X, about Y, or about Z," unless indicated otherwise. The term "about" as used herein can allow for a degree of variability in a value or range, for example, within 10%, within 5%, or within 1% of a stated value or of a stated limit of a range, and includes the exact stated value or range. The term "substantially" as used herein refers to a majority of, or mostly, as in at least about 50%, 60%, 70%, 80%, 90%, 95%, 96%, 97%, 98%, 99%, 99.5%, 99.9%, 99.99%, or at least about 99.999% or more, or 100%.

In this document, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, it is to be understood that the phraseology or terminology employed herein, and not otherwise defined, is for the purpose of description only and not of limitation. Any use of section headings is intended to aid reading of the document and is not to be interpreted as limiting; information that is relevant to a section heading may occur within or outside of that particular section.

In the methods described herein, the acts can be carried out in any order without departing from the principles of the invention, except when a temporal or operational sequence is explicitly recited. Furthermore, specified acts can be carried out concurrently unless explicit claim language recites that they be carried out separately. For example, a claimed act of doing X and a claimed act of doing Y can be conducted simultaneously within a single operation, and the resulting process will fall within the literal scope of the claimed process.

As used herein, "quantum dots" or "QDs" (or QD, singular) refers to semiconductor nanometer structures that confine conduction band electrons, valence band holes and excitons in three spatial directions. This confinement can be attributed to the factors: electrostatic potential (generated by external electrodes, doping, stress or impurity), interface between two different semiconductor materials (for example in self-assembling quantum dots), semiconductor surface (such as semiconductor nanocrystal) or a combination of the above. QD's have a discrete quantized energy spectrum, and the corresponding wave function is located in the quantum dot in space, but extends across several crystal lattice periods. One quantum dot has a small amount of electrons (e.g., from about 1 to about 100), holes or hole-electron pairs, that is, the quantity of electricity it carries is an integral multiple of element of electric-charges. Since electrons and holes are quantumly confined, the continuous energy band structure is transformed into a discrete energy level structure with molecular characteristics, which can emit fluorescence after being stimulated.

The term "radiation" as used herein refers to energetic particles travelling through a medium or space. Examples of radiation are visible light, infrared light, microwaves, radio waves, very low frequency waves, extremely low frequency waves, thermal radiation (heat), and black-body radiation.

The term "UV light" as used herein refers to ultraviolet light, which is electromagnetic radiation with a wavelength of about 10 nm to about 400 nm.

The term "cure" as used herein refers to exposing to radiation in any form, heating, or allowing to undergo a physical or chemical reaction that results in hardening or an increase in viscosity.

The term "coating" as used herein refers to a continuous or discontinuous layer of material on the coated surface, wherein the layer of material can penetrate the surface and can fill areas such as pores, wherein the layer of material can have any three-dimensional shape, including a flat or curved plane. In one example, a coating can be applied to one or more surfaces, any of which may be porous or nonporous, by immersion in a bath of coating material.

The term "surface" as used herein refers to a boundary or side of an object, wherein the boundary or side can have any perimeter shape and can have any three-dimensional shape, including flat, curved, or angular, wherein the boundary or side can be continuous or discontinuous. While the term surface generally refers to the outermost boundary of an object with no implied depth, when the term 'pores' is used in reference to a surface, it refers to both the surface opening and the depth to which the pores extend beneath the surface into the substrate.

As used herein, the term "transparent" means that the level of transmittance for a disclosed composition is greater than 50%. It is preferred that the transmittance be at least 60%, 70%, 80%, 85%, 90%, or 95%, or any range of transmittance values derived from the above exemplified values. In the definition of "transparent", the term "transmittance" refers to the amount of incident light that passes through a sample measured in accordance with ASTM D1003 at a thickness of 3.2 millimeters.

As used herein, the term "refractive index" The terms "refractive index" or "index of refraction" as used herein refer to a dimensionless number that is a measure of the speed of light in that substance or medium. It is typically expressed as a ratio of the speed of light in vacuum relative to that in the considered substance or medium. This can be written mathematically as:

$$n = \text{speed of light in a vacuum} \,/\, \text{speed of light in medium.}$$

As used herein, the term "polymer" refers to a molecule having at least one repeating unit and can include copolymers and homopolymers. The polymers described herein can terminate in any suitable way. In some embodiments, the polymers can terminate with an end group that is independently chosen from a suitable polymerization initiator, -H, -OH, a substituted or unsubstituted $(C_1-C_{20})$hydrocarbyl (e.g., $(C_1-C_{10})$alkyl or $(C_6-C_{20})$aryl) interrupted with 0, 1, 2, or 3 groups independently selected from -O-, substituted or unsubstituted -NH-, and -S-, a poly(substituted or unsubstituted $(C_1-C_{20})$hydrocarbyloxy), and a poly(substituted or unsubstituted $(C_1-C_{20})$hydrocarbylamino).

Illustrative types of polyethylene include, for example, ultra-high molecular weight polyethylene (UHMWPE, for example, a molar mass between 3.5 and 7.5 million atomic mass units), ultra-low molecular weight polyethylene (ULMWPE), high molecular weight polyethylene (HMWPE), high density polyethylene (HDPE, for example, a density of about 0.93 to 0.97 grams per cubic centimeter ($g/cm^3$) or 970 kilograms per cubic meter ($kg/m^3$)), high density cross-linked polyethylene (HDXLPE, for example, a density of about 0.938 to about 0.946 $g/cm^3$), cross-linked polyethylene (PEX or XLPE, for example, a degree of cross-linking of between 65 and 89% according to ASTM F876), medium density polyethylene (MDPE, for example, a density of 0.926 to 0.940 $g/cm^3$), low density polyethylene (LDPE, for example, about 0.910 $g/cm^3$ to 0.940 $g/cm^3$), linear low density polyethylene (LLDPE) and very low density polyethylene (VLDPE, for example, a density of about 0.880 to 0.915 $g/cm^3$).

Examples

An example perovskite film in accordance with the present disclosure was fabricated with the following specifications. The film size of the perovskite film was 110 x 180 mm for green color emission and included zero-dimensional perovskite quantum dots in a film without a barrier layer. The perovskite quantum dots comprised $Cs_4PbBr_6$. PMMA was used as a binder polymer. As shown in Table 1, the example perovskite film is compared to control data including a 3M film (3M Quantum Dot Enhancement Film) comprising quantum dots and a NanoQnt film comprising quantum dots. The 3M and NanoQnt films comprised Cd/ZnS based quantum dots. The quantum dots of these conventional films are disposed in a single layer with barrier layers above and below the QD layer.

**Table 1. Experimental data for perovskite film and control films.**

| Properties | Perovskite film | 3M QD film | NanoQnt QD film |
|---|---|---|---|
| Thickness ($\mu$m) | 251.0$\pm$9.4 | 359.9$\pm$0.7 | 288.4$\pm$0.5 |
| Transmittance (%) | 90.5$\pm$0.1 | 78.7$\pm$0.2 | 73.7$\pm$0.2 |
| Peak Wave Length (nm) | 520.3 | 525.8 | 531.5 |
| FWHM (nm) | 20.7 | 33 | 32.8 |
| Luminance ($Cd/m^2$) | 400 | 1300 | 1314 |

This measurements shown in Table 1 illustrate the possibility of using perovskite films as an alternative to conventional quantum dot film. Based on the perspective of FWHM, the example perovskite material is better than the conventional quantum dot materials measured from 3M and NanoQnt QD films. For example, the FWHM value of 20.7 nm of the perovksite film was smaller than the 33 nm and 32.8 nm FWHM values measured for the 3M and NanoQnt film samples. Since smaller FWHM values correspond to a higher color gamut, the 20.7 nm FWHM value of the perovskite film indicates that the perovskite film has a higher color gamut than the conventional 3M and NanoQnt films. The example perovoksite film had a lower luminance than the 3M and NanoQnt films, but the example perovoskite film did not include any functional enhancement features, such as scattering beads, which can further enhance luminance performance. The following equipment was used to measure luminance, full width half-maximum (FWHM) and peak wave length: Topcon SR-3AR hardware, ATS (ABLEATIVE SYSTEM) software, and Agilent E3632A as a power source supply.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

**Claims**

1. A film comprising:

    a polymer layer;
    a plurality of first quantum dots disposed in the polymer layer and that emit light in a first wavelength range upon excitation, wherein the plurality of first quantum dots comprise a first zero dimensional perovskite material, wherein the first zero dimension perovskite material has an emission property based on a quantum confinement state; and
    a plurality of second quantum dots disposed in the polymer layer and that emit light in a second wavelength range upon excitation, wherein the plurality of second quantum dots comprise a second zero dimensional perovskite material.

2. The film of claim 1, wherein electrical overlap between adjacent octahedra of first zero dimensional perovskite material is minimized in the quantum confinement state.

3. The film of claim 2, wherein the electrical overlap between adjacent octahedra is minimized in comparison to a conventional perovskite material, and wherein the conventional perovskite material is defined by $A_nBX_{n+2}$, wherein A comprises a monovalent cation, B comprises a bivalent cation, X comprises a halogen anion, and n is a number having a value of 1, 2, or 3.

4. The film of any one of claims 1-3, wherein the plurality of first quantum dots disposed in the polymer layer exhibit a higher stability in comparison to a substantially similar composition comprising the first plurality of quantum dots without the first zero dimensional perovskite material.

5. The film of any one of claims 1-4, wherein first zero dimensional perovskite material has a quantum confinement state confining a charge carrier to a molecule of the first zero dimensional perovskite material.

**6.** The film of any one of claims 1-5, wherein the first zero dimensional perovskite material is defined by $A_nBX_{n+2}$, wherein A comprises a monovalent cation, B comprises a bivalent cation, X comprises a halogen anion, and n is a number having a value of at least 4.

**7.** The film of any one of claims 1-6, wherein the first zero dimensional perovskite material comprises a first cation, a second cation, and a halogen anion, wherein the first cation comprises at least four valence electrons, and wherein the first cation comprises $CH_3NH_3$ or Cs, the second cation comprises $Pb_2$, $Sn_2$ or $Bi_2$, and the halogen anion comprises Cl, Br or I.

**8.** The film of any one of claims 1-7, wherein the first zero dimensional perovskite material comprises $Cs_4PbX_6$, where X is Br or I.

**9.** A multi-layer film comprising:

a first layer comprising a plurality of first quantum dots disposed in a first polymer and that emit light in a first wavelength range upon excitation, wherein the plurality of first quantum dots comprise a first zero dimensional perovskite material, wherein the first zero dimension perovskite material has an emission property based on a quantum confinement state; and
a second layer comprising a plurality of second quantum dots disposed in a second polymer and that emit light in a second wavelength range upon excitation, wherein the plurality of second quantum dots comprise a second zero dimensional perovskite material.

**10.** The multi-layer film of claim 9, wherein electrical overlap between adjacent octahedra of first zero dimensional perovskite material is minimized in the quantum confinement state.

**11.** The multi-layer film of claim 10, wherein the electrical overlap between adjacent octahedra is minimized in comparison to a conventional perovskite material, and wherein the conventional perovskite material is defined by $A_nBX_{n+2}$, wherein A comprises a monovalent cation, B comprises a bivalent cation, X comprises a halogen anion, and n is a number having a value of 1, 2, or 3.

**12.** The multi-layer film of any one of claims 9-11, wherein the second zero dimensional perovskite material has an emission property based on a quantum confinement state in which electrical overlap between adjacent octahedra is minimized in comparison to a conventional perovskite material, wherein the conventional perovskite material comprises octahedra forming one or more of one-dimensional chains, two-dimensional planes, or three-dimensional structures.

**13.** The multi-layer film of any one of claims 9-12, further comprising a third layer comprising the plurality of first quantum dots and a fourth layer comprising the plurality of second quantum dots, wherein the third layer and the fourth layer are disposed between the first layer and second layer.

**14.** The multi-layer film of any one of claims 9-13, further comprising a fifth layer disposed between the first layer and the second layer, wherein the fifth layer comprises a polymer and one or more optical enhancement features.

**15.** A method comprising:

forming a plurality of first quantum dots that emit light in a first wavelength range upon excitation, wherein the plurality of first quantum dots comprise a first zero dimensional perovskite material, wherein the first zero dimension perovskite material has an emission property based on a quantum confinement state;
forming a plurality of second quantum dots that emit light in a second wavelength range upon excitation, wherein the plurality of second quantum dots comprise a second zero dimensional perovskite material;
forming a combination of the plurality of first quantum dots, the plurality of second quantum dots, and at least one polymer; and
forming the combination into a structure.

FIG. 1A

FIG. 1B

200

210

130

140

220

**FIG. 2A**

250

130

260

140

130

270

280

290

140

**FIG. 2B**

300

310

320

**FIG. 3A**

300

330

310

320

331

**FIG. 3B**

FIG. 4A

FIG. 4B

400

420

410

FIG. 4C

430

400

420

410

430

FIG. 4D

PROTECTOR SHEET →

PRISM SHEET(H) →

PRISM SHEET(V) →

QD FILM →

LGP
REFLECTOR SHEET
MOLD FRAME

LED →

LED REFLECTOR →

**FIG. 5A**

POL

COLOR FILTER

CELL

TFT

LCD PANEL

POL

BACKLIGHT UNIT

BLU

**FIG. 5B**

600

602

Form a plurality of first quantum dots comprising a first zero dimensional perovskite material

604

Form a plurality of second quantum dots comprising a second zero dimensional perovskite material

606

Form a combination of the plurality of first quantum dots, the plurality of second quantum dots, and at least one polymer

608

Form the combination into a structure

FIG. 6

Europäisches
Patentamt

European
Patent Office

Office européen
des brevets

**EUROPEAN SEARCH REPORT**

Application Number

EP 18 15 9370

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/009530 A1 (UNIV CENTRAL FLORIDA RES FOUND INC [US]) 11 January 2018 (2018-01-11) | 9 | INV. H01L51/42 C09K11/00 C08K3/16 C08K5/17 |
| A | * paragraph [0005] - paragraph [0084]; claims 1-17; figures 1,3,11 * ----- | 1-8, 10-15 | |
| A | HAILONG HUANG ET AL: "Emulsion Synthesis of Size-Tunable CH 3 NH 3 PbBr 3 Quantum Dots: An Alternative Route toward Efficient Light-Emitting Diodes", ACS APPLIED MATERIALS & INTERFACES, vol. 7, no. 51, 16 December 2015 (2015-12-16), pages 28128-28133, XP55431413, US ISSN: 1944-8244, DOI: 10.1021/acsami.5b10373 * page 1 - page 7 * ----- | 1-15 | |
| A | HAIHUA ZHANG ET AL: "Embedding Perovskite Nanocrystals into a Polymer Matrix for Tunable Luminescence Probes in Cell Imaging", ADVANCED FUNCTIONAL MATERIALS, vol. 27, no. 7, 1 February 2017 (2017-02-01), page 1604382, XP55360772, DE ISSN: 1616-301X, DOI: 10.1002/adfm.201604382 * page 28128 - page 28132 * ----- | 1-15 | TECHNICAL FIELDS SEARCHED (IPC) H01L C09K C08K |

The present search report has been drawn up for all claims

| Place of search | Date of completion of the search | Examiner |
|---|---|---|
| The Hague | 8 August 2018 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 15 9370

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2018

| Patent document cited in search report | | Publication date | Patent family member(s) | | Publication date |
|---|---|---|---|---|---|
| WO 2018009530 | A1 | 11-01-2018 | US | 2018010039 A1 | 11-01-2018 |
| | | | WO | 2018009530 A1 | 11-01-2018 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1144075 B1
- US 7741396 B2
- US 6162535 A
- US 20090045544 A1